(19) **Europäisches Patentamt**
**European Patent Office**
**Office européen des brevets**

(11) **EP 3 714 476 B1**

(12) **EUROPEAN PATENT SPECIFICATION**

(45) Date of publication and mention
of the grant of the patent:
**23.06.2021 Bulletin 2021/25**

(21) Application number: **18880978.4**

(22) Date of filing: **08.08.2018**

(51) Int Cl.:
***H05G 2/00*** *(2006.01)*

(86) International application number:
**PCT/RU2018/000520**

(87) International publication number:
**WO 2019/103648 (31.05.2019 Gazette 2019/22)**

(54) **HIGH-BRIGHTNESS LPP SOURCE AND METHODS FOR GENERATING RADIATION AND MITIGATING DEBRIS**

LPP-QUELLE MIT HOHER HELLIGKEIT UND VERFAHREN ZUR ERZEUGUNG VON STRAHLUNG UND MINDERUNG VON RÜCKSTÄNDEN

SOURCE LPP À HAUTE LUMINOSITÉ ET PROCÉDÉS D'ÉMISSION D'UN RAYONNEMENT ET D'ATTÉNUATION DE DÉBRIS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.11.2017 RU 2017141042**

(43) Date of publication of application:
**30.09.2020 Bulletin 2020/40**

(73) Proprietors:
• **RnD-ISAN, Ltd.**
**Moscow 108841 (RU)**
• **ISTEQ B.V.**
**5656 AE Eindhoven (NL)**

(72) Inventors:
• **VINOKHODOV, Aleksandr Yurievich**
**Troitsk**
**Moscow 108840 (RU)**
• **IVANOV, Vladimir Vitalievich**
**Moscow 119421 (RU)**
• **KOSHELEV, Konstantin Nikolaevich**
**Troitsk**
**Moscow 108841 (RU)**
• **KRYVOKORYTOV, Mikhail Sergeyevich**
**Moscow 117447 (RU)**

• **KRIVTSUN, Vladimir Mikhailovich**
**Troitsk**
**Moscow 108840 (RU)**
• **LASH, Aleksandr Andreevich**
**Moscow 127051 (RU)**
• **MEDVEDEV, Vyacheslav Valerievich**
**Troitsk**
**Moscow 108840 (RU)**
• **SIDELNIKOV, Yury Viktorovich**
**Troitsk**
**Moscow 108840 (RU)**
• **YAKUSHEV, Oleg Feliksovich**
**Moscow Region**
**Korolyev 141078 (RU)**

(74) Representative: **Zahn, Matthias et al**
**Peter Bittner und Partner**
**Herrenwiesenweg 2**
**69207 Sandhausen (DE)**

(56) References cited:
**EP-A2- 2 203 033        RU-C2- 2 206 186**
**US-A1- 2012 050 708    US-A1- 2015 076 359**
**US-A1- 2015 282 285    US-A1- 2016 345 419**
**US-B2- 7 307 375**

**Description**

FIELD OF INVENTION

The invention relates to a high-brightness radiation source for generating short-wavelength radiation including x- ray, extreme ultraviolet or vacuum ultraviolet, but mainly in the field of extreme ultraviolet EUV at a wavelength of 13.5nm and to methods for both generating radiation from high-temperature laser produced plasma LPP and mitigating debris. The scope of applications includes various types of inspection such as actinic EUV mask inspection at the working wavelength of the lithographic process.

BACKGROUND OF INVENTION

The new generation projection lithography for large-scale production of integrated circuits IC with structure sizes of 10 nm or less is based on the use of EUV radiation in the range of 13.5+/-0.135nm corresponding to effective reflection of multilayer Mo/Si mirrors. The control of the IC to be defect-free is one of the most important metrological processes of modern nanolithography. The general trend in lithographic production is a shift from IC . inspection, which is extremely time-consuming and costly in large-scale production, to the analysis of lithographic masks. In the case of mask defects they are projected onto a silicon substrate with a photoresist, resulting in the appearance of defects on the printed chips. The mask in EUV lithography is a Mo/Si mirror, on top of which a topological pattern is applied from a material that absorbs radiation at a wavelength of 13.5nm. The most efficient method for the process of mask inspection is carried out at the same wavelength for actinic radiation, that is, radiation, whose wavelength coincides with the working wavelength of the lithography the so- called Actinis Inspection. Such scanning by radiation with a wavelength of 13.5nm allows the detection of defects with a resolution better than 10nm.

Thus, the control of defect-free lithographic masks in the process of their production and during the entire period of operation is one of the key challenges for EUV lithography while the creation of a device for the diagnosis of lithographic masks and its key element - a high- brightness actinic source - is a priority for the development of EUV lithography. For these purposes, it is required to develop a relatively compact and economical device on the basis of an EUV source with high brightness radiation $B_{13.5} \geq 100W/mm^2 \cdot sr$ in the spectral band of 13.5+/- 0.135 nm and with a small value of etendue $G = S \cdot \Omega \leq 10^{-3} \, mm^2 sr$, where S is the source area in $mm^2$, $\Omega$ the solid angle of the output EUV radiation in steradian.

The radiation sources for EUV lithography are using Sn- plasma generated by a powerful laser system including $CO_2$ lasers. Such sources have the power of EUV radiation exceeding by several orders of magnitude the level of power required for the inspection of EUV masks. Therefore, their usage for mask inspection is inadequate due to the excessive complexity and cost. In this regard, there is a need for other approaches to the creation of high-brightness EUV sources for actinic inspection of EUV masks.

In accordance with one of the approaches, known from patent US7307375, issued on 12.11.2007, in a high-brightness source of EUV radiation, a pulsed inductive discharge is used to create an electrodeless Z- pinch in gas, in particular, Xe. The device includes a pulsed power system connected to the primary winding coil of the magnetic core that surrounds part of the discharge zone. In this case, the Z- pinch is formed inside an insulating ceramic SiC sleeve with an opening diameter of about 3 mm. This results in sufficiently strong erosion and means the sleeve requires frequent periodic replacement. The source is characterized by simplicity, compactness and relatively low cost. However, the size of the radiating plasma is relatively large, and the maximum reported brightness of the source ~10 $W/mm^2$ sr is lower than that required for a number of applications, including lithographic mask inspection.

This drawback is largely avoided in the device according to the patent application US20150076359, issued on 19.03.2015 which also includes a new method for generating EUV radiation from laser produced plasma. In the embodiment of this invention, the target material is xenon, which is frozen onto the surface of a rotating cylinder cooled by liquid nitrogen. The laser plasma radiation collected by the collector mirror is directed to an intermediate focus. The device and the method allow the achievement of a small size of plasma emitting in the EUV range, a greater brightness of the radiation source up to 80W/$mm^2$.sr in the absence of any contamination of the optics. The disadvantages of this method include insufficiently high efficiency of the plasma-forming target material and the high cost of xenon which requires a complex system for its recirculation.

From the patent US8344339, issued on 01.03.2012, a known device for the generation of EUV radiation from laser produced plasma including: a vacuum chamber, which houses a rotating rod made of plasma-forming target material, an input window for the laser beam focused in the interaction zone of the laser beam and target, and an EUV beam generated from the laser- produced plasma exiting an output window towards the optical collector. The device and the method of generation of EUV radiation are characterized by the fact that tin Sn is used as the most effective plasma-forming target material and the rod, in addition to rotation, also performs reciprocating axial movements. However, these devices and the method have a number of disadvantages, which include the non-reproducibility of the profile of the solid surface of the target from pulse to pulse during long-term continuous operation of the device, which affects the stability of the output characteristics of the short-wavelength radiation source. The complexity of the design is another disadvantage, since complex movements of the target assembly and its periodic replacement are required. During production of EUV radiation, debris particles are produced as a by-product, which can degrade the optics surface. The level of debris produced in this source is too high and that severely limits the possibilities of its application.

The debris, generated as a by-product of the plasma during the radiation source operation, can be in the form of high-energy ions, neutral atoms and clusters of target material.

The magnetic mitigation technique, disclosed for example in United States Patent 8519366, issued on 27.08.2013, is arranged to apply a magnetic field so that at least charged debris particles are mitigated. In this patent the debris mitigation system for use in a source for EUV radiation and/or X- rays, includes a rotatable foil trap and gas inlets for the supply of buffer gas to the foil trap so that neutral atoms and clusters of target material are effectively mitigated.

Another debris mitigating technique, known from United States Patent 7302043, issued on 27.11.2007, is arranged to apply a rotating shutter assembly configured to permit the passage of short-wavelength radiation through at least one aperture during the first period of rotation, and to thereafter rotate the shutter to obstruct passage of the debris through at least one aperture during the second period of rotation.

However, the complexity of using these debris-mitigating techniques in a compact radiation source means that technically they are too difficult to implement.

SUMMARY OF THE INVENTION

The technical problem to be solved by the invention refers to the creation of high-brightness, low-debris radiation sources based on laser-produced plasma mainly for EUV metrology, inspection of nano - and microstructures, including an actinic inspection of masks in EUV lithography.

Achievement of the purpose is possible by means of an apparatus for generating short-wavelength radiation from a laser-produced plasma LPP, which includes a vacuum chamber containing a rotational drive unit coupled to a rotating target assembly which supplies a target to an interaction zone, an input window for a pulsed laser beam focused into the interaction zone, an output window for the exit of the short-wavelength radiation beam and gas inlets.

The apparatus is characterized in that the rotating target assembly has an annular groove with a distal wall and a proximal wall relative to the axis of rotation; the plasma-forming target material is a molten metal located inside the annular groove, and the target is a layer of said molten metal formed by centrifugal force on the surface of the distal wall of the annular groove, and the proximal wall of the annular groove is designed to provide a line of sight between the interaction zone and both the input and output windows particularly during laser pulses.

In the embodiment of the invention the proximal wall of the annular groove has n pairs of openings arranged on a groove circumference, in each of the pairs, a first opening is provided for the focused laser beam input into the interaction zone, and a second opening is provided for the short-wavelength radiation beam output from the interaction zone during the laser pulses that follow at a frequency f equal to a target assembly rotational speed $\nu$ multiplied by the number of the opening pairs n: $f = \nu.n$, further comprising a synchronization system which adjusts the annular groove rotation angle with the laser pulses timed to provide a line of sight between the interaction zone and both the input and output windows. In other variants of the invention, the proximal wall of the annular groove has a slit along the entire perimeter of the groove, providing direct visibility between the interaction zone on the one hand and the input and output windows on the other.

In the embodiment of the invention, each twin openings may be joined.

In another embodiment, the proximal wall of the annular groove has a slit along its entire perimeter providing a line of sight between the interaction zone and both the input and output windows.

In an embodiment of the invention, the rotating target assembly is provided with a fixed heating system for the target material.

In a preferred embodiment of the invention, the laser beam and the short-wavelength radiation beam are located on one side of a rotation plane passing through the interaction zone, and a normal vector to the annular groove surface in the interaction zone is located on the opposite side of the rotation plane.

In a preferred embodiment of the invention, the laser beam and the short-wavelength radiation beam are located on one side of a rotation plane passing through the interaction zone, and the rotational drive unit is located on the opposite side of the rotation plane.

In a preferred embodiment of the invention, the annular groove is provided with a cover.

In a preferred embodiment of the invention, a part of the focused laser beam between the input window and the proximal wall of the annular groove is surrounded by a first casing in which a gas flow from the input window to the proximal wall of the annular groove is supplied, and a part of the short-wavelength radiation beam between the proximal wall of the annular groove and the output window is surrounded by a second casing in which a gas flow from the output window to the proximal wall of the annular groove is supplied.

In a preferred embodiment of the invention, devices for magnetic field generation are arranged on the outer surfaces of the said first and second casings.

In an embodiment of the invention, the first and second casings may be integrated together.

In an embodiment of the invention, the input and output windows may be provided with heaters performing highly efficient cleaning by evaporation of debris from the windows.

In an embodiment of the invention, the input and output windows are provided with a system of gas chemical cleaning.

In a preferred embodiment of the invention, the plasma-forming target material is selected from metals providing highly efficient extreme ultraviolet EUV light generation, particularly including Sn, Li, In, Ga, Pb, Bi or their alloys.

In another aspect, the invention relates to a method for generating radiation from a laser-produced plasma, comprising: forming a target by centrifugal force as a layer of molten metal on a surface of an annular groove, implemented inside a rotating target assembly; sending a pulsed laser beam through an input window of a vacuum chamber into an interaction zone while providing a line of sight between the interaction zone and both the input and output windows particularly during laser pulses, irradiating a target on a surface of a rotating target assembly by a laser beam, and passing a generated short-wavelength radiation beam through an output window of a vacuum chamber.

In yet another aspect, the invention relates to a method for mitigating debris in a laser- produced plasma LPP source, characterized by irradiating a target on a surface of a rotating target assembly with a pulsed laser beam, while the laser beam enters through the input window and a generated short-wavelength radiation beam exits through the output window of a vacuum chamber, said method comprising: the target formation by centrifugal force as a layer of molten metal on a surface of an annular groove, implemented inside the rotating target assembly, and using an orbital velocity $V_R$ of the rotating target assembly high enough for the droplet fractions of the debris particles exiting the rotating target assembly not to be directed towards the input and output windows

In the embodiment of the invention, the groove has a distal wall and a proximal wall relative to an axis of rotation; the proximal wall has n pairs of openings arranged for the focused laser beam input into an interaction zone and for a short-wavelength radiation beam output from the interaction zone during the laser pulses that follow at a frequency f equal to an orbital velocity $V_R$ of rotating target assembly multiplied by the number n of the opening pairs and divided by the length of the orbital circle $2\pi R$: $f = V_R \cdot n/(2\pi R)$, said method comprising: forming the target on a surface of the distal wall of the annular groove, providing a line of sight between the interaction zone and both the input and output windows by means of two openings, irradiating a target on the surface of a rotating target assembly by a laser beam and passing a generated short-wavelength radiation beam through the output window of a vacuum chamber, restricting a debris flow generated from the interaction zone by apertures of two openings, obstructing the passage of the debris through the proximal wall by closing the line of sight between the interaction zone and both the input and output windows due to rotation of the proximal wall until the next cycle of operation.

In a preferred embodiment of the invention, said openings are elongated channels, which act as rotating debris-trapping surfaces, and said method comprising: trapping the debris particles on the surfaces of the two extended channels and ejecting the trapped debris particles by centrifugal force back into the groove.

In a preferred embodiment of the invention, debris mitigation techniques such as magnetic mitigation, gas curtain and foil traps are additionally used.

The technical result of the invention is the creation of a high-brightness source of the short-wavelength radiation with an extremely low debris level, which ensures an increase in lifetime and a reduction in operating costs.

The foregoing and other objects, advantages and features of the present invention will become more apparent from the following non-limiting description of exemplary embodiments thereof, given by way of example with reference to the accompanying drawings.

BRIEF DESCRIPTION OF THE DRAWINGS

The essence of the invention is explained by the drawings, in which:

FIG. 1 schematically illustrates a device and method for generating radiation from laser-produced plasma in accordance with embodiments of the present invention,
FIG. 2, FIG. 3, FIG. 4 and FIG. 5 show the characteristic emission spectra of laser plasma for various target materials, providing highly efficient EUV light generation,
FIG. 6 and FIG. 7 schematically show the mechanism of mitigating the droplet fractions of the debris in accordance with the present invention,
FIG. 8 schematically shows the mechanism of obstructing the passage of the debris through the openings in the rotating target assembly. In the drawings, the matching elements of the device have the same reference numbers.

These drawings do not cover and, moreover, do not limit the entire scope of options for implementing this technical solution, but are only illustrative materials of particular cases of its implementation.

DETAILED DESCRIPTION OF PREFERRED EMBODIMENTS

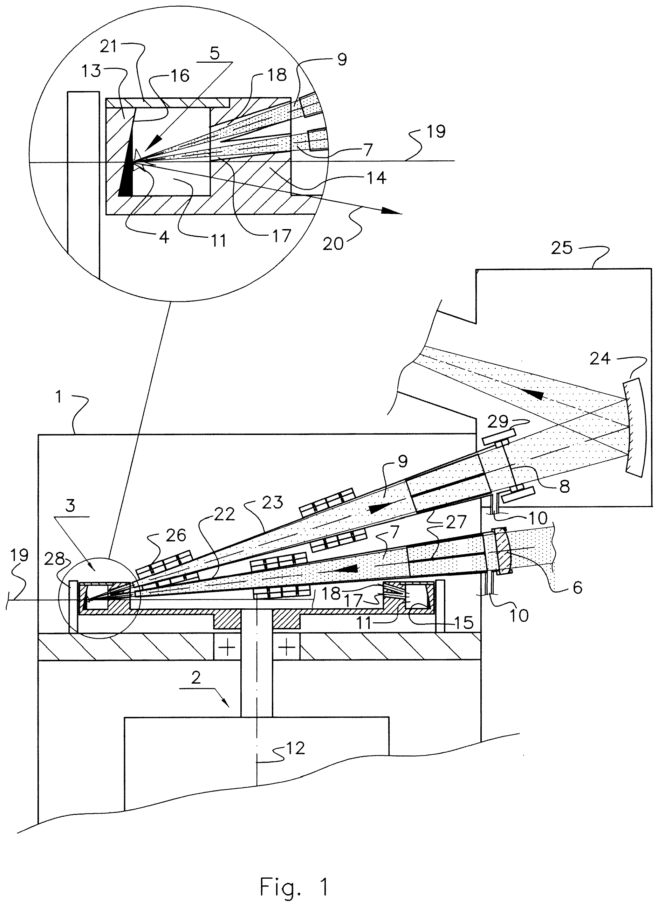

According to the embodiment of the invention schematically shown in FIG. 1, an apparatus for generating short-wavelength radiation from laser-produced plasma LPP comprises: vacuum chamber 1 containing a rotating target assembly 3 which supplies a target 4 to an interaction zone 5, an input window 6 for a pulsed laser beam 7 focused into the interaction zone, an output window 8 for an exit of the short-wavelength radiation beam 9, and gas inlets 10.

The rotating target assembly 3 has an annular groove 11 with a distal wall 13 and a proximal wall 14 relative to the axis of rotation 12.

The plasma-forming target material 15 is a molten metal located inside the annular groove 11, and the target 4 is a layer of said molten metal formed by a centrifugal force on a surface 16 of the distal wall 13 of the annular groove 11.

The proximal wall 14 of the annular groove 11 is designed to provide a line of sight between the interaction zone 5 and both the input and output windows 6, 8 particularly during laser pulses. For this purpose the proximal wall 14 can have for example either the first and second openings 17, 18, shown in Fig. 1, or a slit along its entire perimeter.

The rotating target assembly 3 is preferably disc-shaped. However, it can have the shape of a wheel, a low polyhedral prism, or another shape.

The apparatus for generating radiation from laser-produced plasma implemented in accordance with the present invention has the following advantages:

- the use of a liquid-phase target, in contrast to solid, ensures the reproducibility of the target surface, which increases the pulse to pulse stability of the output characteristics of the short-wavelength radiation source,
- long-term stability of the short-wavelength radiation source is achieved due to continuous circulation, renewal and replenishment of the target material in the interaction zone,
- the use of laser-produced plasma of metals, in particular tin Sn, ensures both high brightness and high efficiency of the short-wavelength radiation source, in particular, at the working wavelength, 13.5nm, of the EUV lithography,
- unlike analogues, the proposed design of the rotating target assembly sharply limits the outflow of debris particles beyond it, ensuring the cleanliness of the short-wavelength radiation source and minimum consumption of the target material,
- simplifies the design of the apparatus, reduces the cost of its operation.

In the embodiment of the present invention, schematically shown in FIG. 1, to provide a line of visibility between the interaction zone 5 and both the input and output windows 6, 8, the proximal wall 14 of the annular groove 11 has n pairs of openings 17 and 18 arranged on a groove circumference. In each of the pairs, a first opening 17 is provided for a focused laser beam 7 input into the interaction zone 5, and a second opening 18 is provided for a short-wavelength radiation beam 9 output from the interaction zone during the laser pulses that follow at a frequency f equal to a target assembly rotational speed $\nu$ multiplied by the number of the opening pairs n: $f = \nu \cdot n$. The number of pairs of openings n can be in the range of several tens to hundreds.

In this embodiment of the invention, the apparatus can operate using a synchronization system for simplicity (not shown) which adjusts an annular groove 11 rotation angle with laser pulses timed to provide a line of sight between the interaction zone 5 and both the input and output windows 6 and 8.

Synchronization system can include an auxiliary continuous wave laser irradiating the surface of the rotating target assembly with n radial markers located along its circumference, each of which is at the same angle to the axis of one of the n first openings 17. In this case, the photodetector detects a reflected continuous signal of the auxiliary laser radiation, modulated by the markers and starts the main pulsed laser at the rotation angles of the annular groove 11, which provide a line of visibility between the interaction zone 5 and the input and output windows 6, 8 through the first and second openings 17, 18 in the proximal wall 14.

In this embodiment, the strongest restriction of the debris flux is achieved, since there is only one pair of small openings 17, 18 through which the exit of debris from the rotating target assembly 3 is possible. Along with this, obstruction of the passage of the debris through the proximal wall 14 is provided by closing the line of sight between the interaction zone 5 and both the input and output windows 6, 8 due to rotation of the proximal wall 14 until the next cycle of short-wavelength radiation generation.

The micro droplets of the target material, passing into the openings 17, 18, for the most part move at an angle to the axis of these openings. Therefore, with a high probability, the micro droplets fall onto the rotating wall of the openings, are absorbed by surfaces and then are ejected back into the annular groove 11 under the action of a centrifugal force. Thus the plasma-forming material of the target does not leave the annular groove 11, increasing the source lifetime without the need for refueling.

Preferably, openings 17, 18 are elongated channels, which efficiently absorb the debris particles on their surfaces and then eject the trapped debris particles by centrifugal force back into the annular groove 11.

The axis of the openings 17 and 18 may be located on one surface of rotation, or on different surfaces of rotation, as shown in FIG. 1. The shape of the first and second openings 17, 18 in the proximal wall 14 of the annular groove 11 may be cylindrical, conical, rectangular or slotted but not limited thereto. Each twin openings 17 and 18 may be joined or combined together.

In another embodiment of the invention the proximal wall 14 of the annular groove 11 has a slit along its entire perimeter providing a line of sight between the interaction zone 5 and both the input and output windows 6 and 8. In this arrangement synchronization between laser pulses and the rotation angle of the annular groove 11 is not required. This simplifies the operation of the apparatus at high pulse repetition frequency f, even up to 10MHz.

The orbital velocity $V_R$ of the target 4 on the distal wall 13 of the rotating target assembly 3 is mainly perpendicular to both the direction of the laser beam 7 and the short-wavelength radiation beam 9, which prevents debris particles from getting into windows 6 and 8. So, to prevent the droplet fractions of the debris particles exiting the rotating target assembly 3 from being directed towards the input and output windows 6 and 8, the orbital velocity $V_R$ of the rotating target assembly 3 should be high enough.

In the coordinate system of the rotating target assembly 3 the movement of plasma, vapor, clusters and droplets of the target material from the interaction zone 5 occurs substantially in the direction close to that of the normal vector 20 to the surface of the target 4 in the interaction zone 5. When the rotational speed is high enough, the surface of the target 4 is parallel to the axis of rotation 12 and the normal to its surface lies in the plane of rotation 19, which crosses interaction zone 5. Because of this, in preferable embodiments of the invention the laser beam 7, except for its apex, and the short-wavelength radiation beam 9, except for its apex, are situated outside the rotation plane 19 which crosses interaction zone 5. This additionally prevents debris particles from getting into the windows 6 and 8.

When the centrifugal force is high enough, the surface of the target 4 is parallel to the axis of rotation 12 and the normal to its surface lies in the plane of rotation 19, which crosses interaction zone 5. Because of this, in preferable embodiments the laser beam 7, except for its apex, and the short-wavelength radiation beam 9, except for its apex, are situated outside the rotation plane 19. This also prevents debris particles from getting into the windows 6 and 8.

Another substantial direction of the ejection of the debris particles from interaction zone 5 is determined by the following factor; the shock wave caused by the laser inside the target 4 after being reflected from the surface 16 of the annular groove 11 can produce ejection of micro droplets oriented mainly in the normal vector 20 to the surface 16. Because of this, to prevent debris particles from getting into the windows 6 and 8, the laser beam 7 and the short-wavelength radiation beam 9 are preferably located on one side of a rotation plane 19 passing through the interaction zone 5, and a normal vector 20 to the annular groove surface 16 in the interaction zone 5 is located on the opposite side of the rotation plane 19.

In these embodiments of the invention the substantial directions of ejection of debris particles differ significantly from directions to input and output windows 6 and 8 and the proximal wall 9 of the annular groove becomes an effective protection shield preventing the exiting of debris particles from the rotating target assembly 3.

The proximal wall 14 of the annular groove 11 can have at least one annular cavity or groove or may be doubled or tripled to improve the blocking of the debris particles from leaving the rotating target assembly 3.

Also to prevent the debris particles from leaving the rotating target assembly 3 the annular groove 11 preferably is provided with a cover 21.

For additional protection of the windows 6 and 8 from debris particles including plasma and vapor of the molten metal, a part of the focused laser beam 7 between the input window 6 and the proximal wall 14 of the annular groove 11 is surrounded by a first casing 22 in which a gas flow from the input window 6 to the proximal wall 14 of the annular groove 11 is supplied. Similarly, a part of the short-wavelength radiation beam 9 between the proximal wall 14 of the annular groove 11 and the output window 8 is surrounded by a second casing 23 in which a gas flow from the output window 8 to the proximal wall 14 of the annular groove 11 is supplied. Gas flows are supplied by means of gas inlets 10.

The output window 8 of the vacuum chamber 1 may be an opening or may have a spectral filter with relatively high transparency for short-wavelength radiation. The short-wavelength radiation can be directed to a collector mirror 24 located outside the vacuum chamber 1 in the optical box 25 which is filled with an inert gas.

The gas flows inside the casings 22 and 23 prevent plasma and vapor of the target material from moving towards the windows 6 and 8 thus protecting them from contamination.

For further protection from the ion streams, the devices for magnetic field generation 26, for example permanent magnets, are arranged on the outer surfaces of the first and second casings 22 and 23. The magnetic fields are oriented preferably across the axis of laser beam 7 and short-wavelength radiation beam 9 to prevent plasma from moving towards windows 6 and 8.

Foil traps, combining high radiation transparency and a large surface area for the deposition of debris particles, may be installed in the first and second casings 22 and 23 to provide additional improvement of debris mitigation.

In the embodiments of the invention the first and second casings 22 and 23 may be integrated together.

To avoid blocking of the focused laser beam 7 and the short-wavelength radiation beam 9 by the rotational drive unit 2, the beams 7, 9 are preferably located on one side of a rotation plane 19 passing through the interaction zone 5, and the rotational drive unit 2 is located on the opposite side of the rotation plane 19, as shown in FIG. 1

Different variants of design of the rotating target assembly 3 may have axis of rotation 12 vertical or inclined to vertical.

Preferably, the target assembly rotational speed (v) is high enough, ranging from 20Hz to 10kHz, to provide the following factors:

- Most of the droplet fractions of the debris particles exiting the rotating target assembly 3 are not directed towards the input and output windows 6, 8,
- the surface of the target 4 is close to parallel to the axis of rotation 12,
- in the arrangement with openings 17, 18, they obstruct the passage of the debris through the proximal wall 14 by closing the line of sight between the interaction zone 5 and both the input and output windows 6, 8 due to rotation of the proximal wall 14 until the next cycle of radiation generation,
- droplets flying into openings 17, 18 collide with the walls of these openings, which trap the debris particles,
- centrifugal force is large enough to eject the trapped droplets with dimensions $\sim 100\ \mu$m and less back to the annular groove 11.

The debris particles consist of droplets, vapor and ions of the molten metal. Typical velocity of droplets is $\sim 10^2$ m/s for Sn and $\sim 10^3$ m/s for Li, $\sim 10^3$ m/s for vapor, $10^5$ m/s for ions.

Overall, if the high-brightness LPP source of short-wavelength radiation is made according to the present invention its purity is achieved due to the following factors:

- the high orbital velocity of the rotating target assembly provides extremely efficient mitigation of the droplet fraction and partial mitigation of the vapor fraction of the debris,
- gas flows effectively mitigate the vapor fraction and partially the ion fraction of the debris,
- magnetic fields effectively mitigate the ion fraction of the debris particles.

In the preferred embodiments of the invention the rotating target assembly 3 is provided with a fixed heating system 28 for the target material 15. To keep the target material in a molten state inside the rotating target assembly 3 the heating system 28 should provide no contact induction heating. The fixed heating system 28 may have the option of keeping the temperature of molten metal in the optimal range of temperature.

When metals, such as lithium, with high pressure of saturated vapor are used, the input and output windows 6, 8 may be provided with heaters 29 which perform highly efficient evaporation cleaning of debris from the windows 6, 8 by heating them up to 400-500 °C. This temperature ensures that the pressure of Li saturated steam is higher than the pressure of incoming steam. FIG. 1 shows heater 29 only for output window 8, although such evaporating cleaning can be used for input window 6 as well.

In addition input and output windows 6 and 8 may be fitted with a system of gas chemical cleaning. A cleaning gas is employed to remove any deposited debris material that has formed as a thin film on the windows' surfaces. The gas used may be any of the following: hydrogen, hydrogen-containing gas, oxygen-containing gas, fluorine gas, chlorine fluoride gas, bromine fluoride gas or iodine fluoride gas. In accordance of one of the embodiments of the invention the short-wavelength radiation pulses generate low-temperature plasma, along with photo-induced surface activation. Together these combine to yield a highly reactive environment that quickly and efficiently removes deposited debris. By controlling the cleaning gas partial pressure and surface temperature, the plasma environment and cleaning rates can be controlled with a relatively high level of precision. For this the heaters 29 can be used in conjunction with a system of gas chemical cleaning. Currently atomic hydrogen is mainly used to remove different types of contaminants because the majority of basic hydrogen compounds are volatile.

To produce high-temperature laser-produced plasma with high optical output in short- wavelength spectra from ultraviolet to soft x- ray band, the density of power of laser radiation on the target should be from $10^{10}$ to $10^{12}$W/cm$^2$ and the length of laser pulses - from 100ns to 0.5ps.

To generate the laser beam 7 any pulsed or modulated laser or several lasers may be used. The laser may be solid state, fiber, disk, or gas discharge . The average power of laser radiation can be in the range from 10W up to about 1kW or more with focusing of the laser beam on a small focus spot on a target, for instance about $100\mu$m in diameter.

The laser pulse repetition frequency f can be from 1kHz to 10MHz. In this range a higher pulse repetition rate at lower output laser energy is preferable for reducing the splash of debris particles.

In the embodiments of the invention the plasma-forming target material is selected from metals providing highly efficient extreme ultraviolet (EUV) light generation, particularly Sn, Li, In, Ga, Pb, Bi or their alloys.

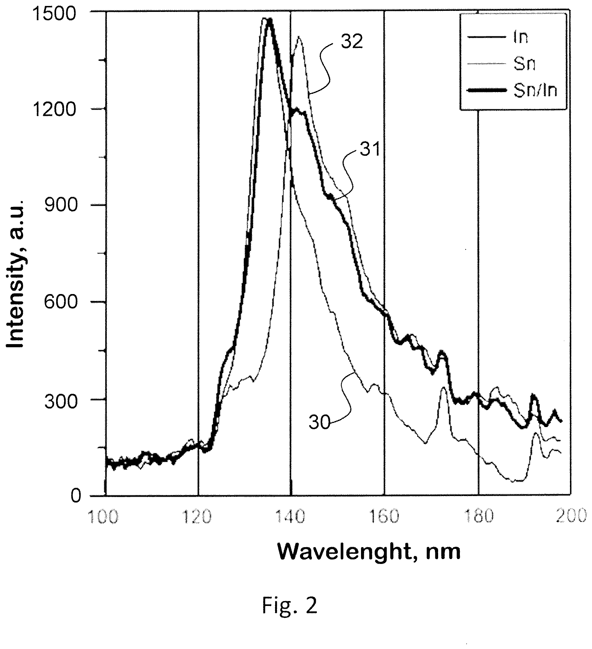

Figure 2 shows spectra of laser-produced plasma 30, 31 and 32 obtained under the same conditions, where the target material is pure Sn, eutectic alloy Sn/In=52/48 (ratio defines alloy composition) and pure In, respectively. It can be observed, that using these target materials, a similarly high spectral brightness in the EUV region is reached. Using Sn or Sn alloy is preferable for achieving high brightness at 13.5nm while having high conversion efficiency ($CE_{13.5}$)

of laser energy into in-band EUV energy within 13.5 nm+/- 0.135nm. Utilizing a eutectic alloy Sn/In may be preferable, because the alloy's melting temperature is 125°C, significantly lower than the melting temperature of pure Sn which is 232°C.

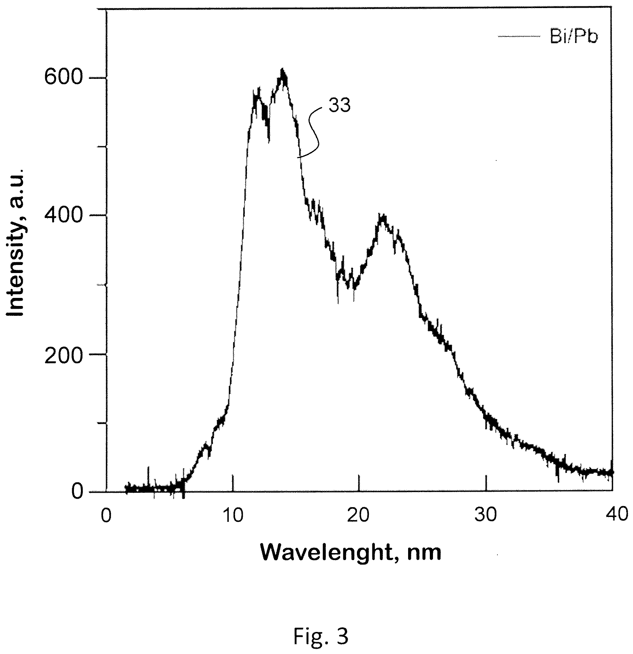

A low-melting temperature target material can also be chosen to contain Bi, Pb and their alloys, in particular, a eutectic alloy Bi/Pb=56.5/43.5, having a melting temperature of 125°C. Fig.3 depicts a spectrum 33 of a laser-produced plasma using Bi/Pb eutectic alloy as a target. Spectrum is selected to have maximum intensity in the EUV region.

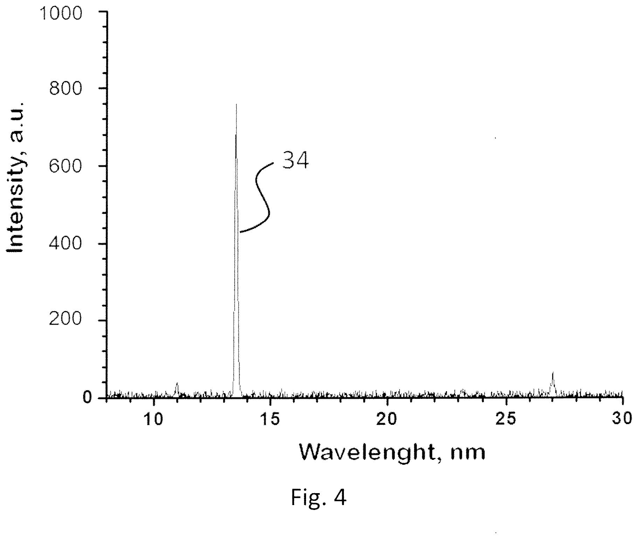

Fig.4 shows a spectrum 34 of laser-produced plasma, using Li as a target material. Using Li as a target material may be preferable due to

- high conversion efficiency $CE_{13.5}$ up to 2.5%,
- high saturated vapor pressure of Li, providing efficient evaporative cleaning of optical elements at 400- 500°C,
- high spectral purity of a light source, which decreases radiative load on EUV optics,
- low atomic weight of Li and low energy of ions produced by Li plasmas, both decrease risk of optical elements degradation due to ion bombardment, in particular, for a spectral purity filter used as output window.

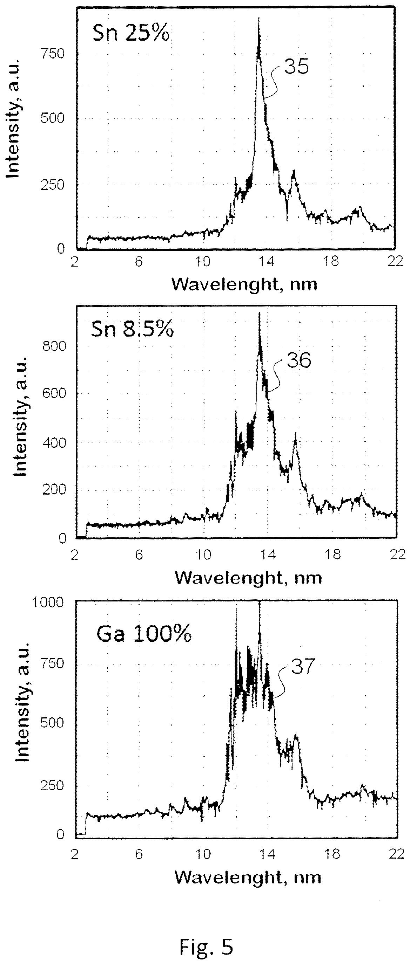

Lower melting temperatures, close to room temperature, can be achieved by using Ga and its alloys as a target material. Fig 5 shows spectra 35, 36, 37 of laser-produced plasma, where a target material was chosen to be an alloy Sn/Ga=8.5/91.5, Sn/Ga=25/75 and Ga respectively. These target materials allow the achievement of high intensity EUV radiation at low melting temperatures, 20-30°C. Low target melting temperature in turn simplifies the engineering of an apparatus for generating radiation from laser-produced plasmas.

Spectra in Fig 2, Fig 3, Fig 4 and Fig 5 were obtained with a solid state Nd-YAG laser, operating at wavelength of 1064nm, laser pulse duration of 17ns and laser power density on the target of $1.1 \cdot 10^{11}$ W/cm$^2$.

As an example, a high-brightness LPP EUV light source for EUV mask inspection in accordance with the present invention may be designed (but not limited to) as follows:

- type of laser: solid state or fiber
- laser wavelength $\lambda$= 1- 2um
- pulse repetition frequency 10- 30kHz
- laser pulse energy 1- 50mJ/pulse
- orbital target velocity up to 200m/s
- conversion efficiency $CE_{13.5}$ - up to 3%
- EUV radiation collection solid angle, $\Omega$= 0.04sr
- brightness of EUV source $B_{13.5}$- up to 2kW/mm$^2$sr.

A method for generating short-wavelength radiation, realized in particular in a high-brightness LPP source schematically shown in FIG. 1, comprises: forming a target 4 by centrifugal force as a layer of molten metal on a surface 16 of an annular groove 11, implemented inside a rotating target assembly 3; sending a pulsed laser beam 7 through an input window 6 of a vacuum chamber 1 into an interaction zone 5 while providing a line of sight between the interaction zone 5 and both the input and output windows 6, 8 particularly during laser pulses. The method further comprises irradiating a target 4 on a surface of a rotating target assembly 3 by a laser beam 7 and passing a generated short-wavelength radiation beam 9 through an output window 8 of a vacuum chamber 1.

The vacuum chamber 1 is evacuated with an oil-free pump system to below $10^{-5}$-$10^{-8}$ bar, thus removing gas components such as nitrogen and carbon which are capable of interacting with the target material.

The rotating target assembly 3 is driven by means of an electromotor with a shaft or by any other rotational drive unit

The target material is preferably kept molten using an inductive heating system 28, configured to permit temperature stabilization of target material in order to keep it within the optimal temperature range.

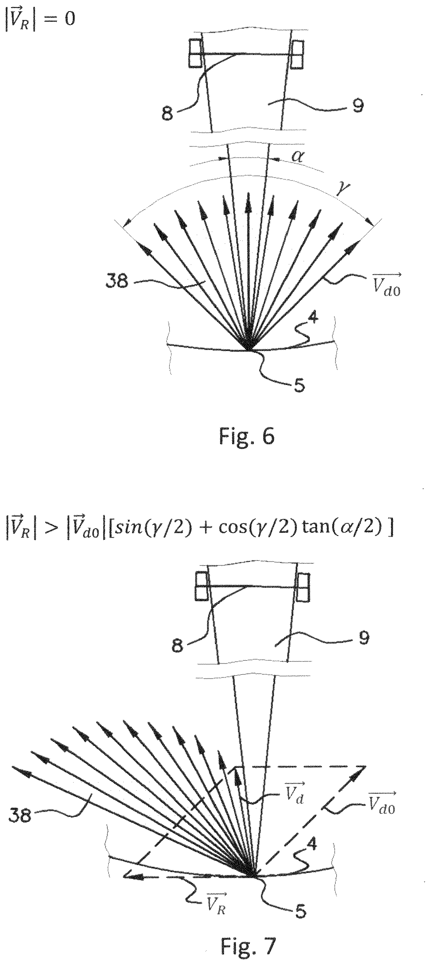

The new method for mitigating debris particles realized in the description above of a high-brightness LPP source for short-wavelength radiation, is schematically illustrated by FIG. 6 and FIG. 7, which show the velocity diagrams in flow 38 of the droplet fractions of the debris.

FIG. 6 depicts the hypothetical case when: the orbital velocity $V_R$ of the target 4 is zero: $V_R$= 0; the characteristic escape velocity of the droplet fractions is $V_{d0}$, the short-wavelength radiation beam 9 is characterized by the opening angle $\alpha$ while flow 38 of the droplet fractions is characterized by the total escape angle $\gamma$. The angle $\alpha$ also corresponds to the collection angle of the output window 8 of the LPP source. In the case when $V_R$= 0, flow 38 of the droplet fractions is substantially directed towards the output window 8, as shown in FIG. 6.

However, if the velocity vector $\vec{V}_{d0}$ of each droplet is added to a sufficiently large orbital velocity component $\vec{V}_R$, the situation will change so that flow 38 of the droplet fractions will not be directed towards the output window 8 (and/or to input window 6), as shown in FIG. 7. So in accordance with the above simplified consideration, a method for mitigating debris in a LPP source constructed according to the present invention, consists of using an orbital velocity $V_R$ for the rotating target assembly (3) high enough for the droplet fractions of the debris particles exiting the rotating target assembly not to be directed towards the input and output windows (6) and (8).

The condition that the flow of droplet fractions is not directed to the input or output windows 6, 8, as shown in FIG. 7, is described by the following expression:

$$\left|\vec{V}_R\right| \geq \left|\vec{V}_{d0}\right|\left[sin(\gamma/2) + cos(\gamma/2)\tan(\alpha/2)\,\right] \qquad (1).$$

For example, when Sn is used as a plasma-forming target material, the characteristic escape velocity of the droplet fractions is $V_{d0} \approx 100$ m/s. Then for the collection angle $\alpha \approx 12°$, total escape angle $\gamma = 90°$ and the radius of the target orbital circle R = 10cm, the orbital velocity $V_R$ of the target 4 should be 80m/s or higher. This example corresponds to an embodiment of the invention for which the proximate wall 14 of the annular groove 11 has a slit along its entire perimeter to provide a line of sight between the interaction zone and both the input and output windows.

In another embodiment of the invention, illustrated by FIG. 1, improved mitigation of all types of debris particles is achieved due to the restriction of the debris flow by the apertures of the two openings 17, 18 in the proximal wall 14, which provide a line of sight between the interaction zone 5 and both the input and output windows (6) and (8) during laser pulses. In this embodiment improved mitigation of debris particles is also achieved due to the obstruction of the passage of the debris through the proximal wall 14, by closing the line of sight between the interaction zone 5 and both the input and output windows 6, 8 due to rotation of the proximal wall 14 until the next cycle of short-wavelength radiation generation.

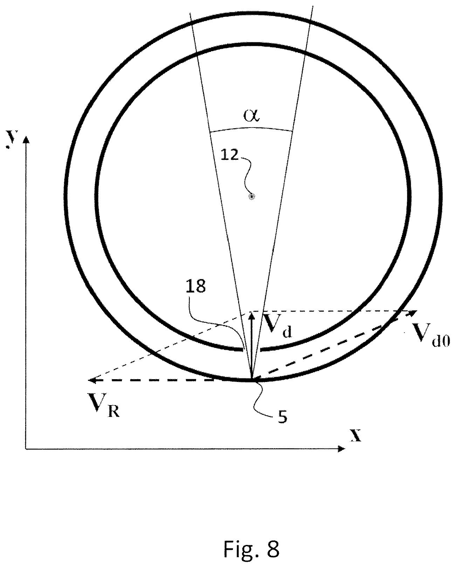

FIG. 8 schematically shows the mechanism of obstructing the passage of the debris through the openings 18 in the rotating target assembly. As seen from FIG. 8, all droplets created at interaction zone 5 with velocity $V_x < V_R$ do not fall into the radiation collection angle $\alpha$. Only the part of the droplets, whose total velocity $V_{d0}$ (in a rotating coordinate system) exceeds $V_R$, and the component Vx, is close to $V_R$ - are directed into the collection angle a.

If such a droplet has a velocity $V_y$ in the direction of collection angle a, then it takes time $\Delta t = \Delta R/V_y$ to traverse the distance $\Delta R$ between the distal and proximal walls. The opening 18 for the short-wavelength beam output will shift to $\Delta x = V_R \cdot \Delta T$. The size d of this opening 18 is given by the radiation collection angle: $d = 2 \cdot \Delta R \cdot sin(\alpha/2)$. If the displacement is greater than the diameter of this opening, then the droplets do not pass into it, i.e. the droplets with $V_y < V_R/(2 \cdot sin(\alpha/2))$ are cut off. So for $sin(\alpha/2) = 0.1$ and $V_R = 200$ m/s all droplets with the velocity $V_{d0}$ less than $(V_y^2 + V_R^2)^{1/2} = 1020$ m/s are obstructed or cut off.

So the proposed method of debris mitigation provides the obstruction of the passage of debris through the proximal wall, by closing the line of sight between the interaction zone 5 and both the input and output windows 6, 8 due to rotation of the proximal wall until the next cycle of operation.

To improve debris mitigation, the openings 17, 18 may be made in the form of elongated channels whose surfaces act as rotating debris-traps and eject the trapped debris particles by centrifugal force back into the groove 11, FIG. 1. Along with this the twin openings 17 and 18 may be joined to simplify the design and operation of the LPP source.

To prevent the ionized and neutral debris particles from moving towards windows 6 and 8, the devices for magnetic field generation 26, foil traps 27 and buffer gas flows to the foil trap or the gas curtains, provided by gas inlets 10 are additionally used in preferred embodiments of the invention, FIG. 1.

In general, an apparatus and methods, arranged in accordance with the present inventions, provide a high-brightness low-debris short-wavelength radiation source characterized by long lifetime and low cost of operation.

INDUSTRIAL APPLICATIONS

The proposed apparatus and method are intended for a variety of applications, including EUV metrology and inspection of nano- and microstructures. One of the main results of the invention is to enable the development of a radiation source that meets the requirements of light sources for actinic mask inspection in EUV lithography.

LIST OF SYMBOLS

| 1. | vacuum chamber | 20. | normal to the distal wall |
|---|---|---|---|
| 2. | rotational drive unit | 21. | cover |
| 3. | rotating target assembly | 22. | first casing |
| 4. | target | 23. | second casing |

(continued)

| 5. | interaction zone | 24. | collector mirror |
|---|---|---|---|
| 6. | input window | 25. | optical box |
| 7. | laser beam | 26. | devices for a magnetic field generation |
| 8. | output window | 27. | foil trap |
| 9. | short-wavelength radiation beam | 28. | fixed heating system |
| 10. | gas inlets | 29. | heater |
| 11. | annular groove | 30. | spectrum of Sn- plasma |
| 12. | axis of rotation | 31. | spectrum of Sn/In 52/48-plasma |
| 13. | distal wall | 32. | spectrum of In plasma |
| 14. | proximal wall | 33. | spectrum of Bi/Pb56,5/43,5-plasma |
| 15. | molten metal | 34. | .spectrum of Li-plasma |
| 16. | inner surface of the distal wall | 35. | spectrum of Sn/Ga8,5/91,5- plasma |
| 17. | n first openings | 36. | spectrum of Sn/Ga25/75- plasma |
| 18. | n second openings | 37. | spectrum of Ga- plasma |
| 19. | plane of rotation passing through the interaction zone | 38. | flow of the droplet fractions |

**Claims**

1.  An apparatus for generating a short-wavelength radiation beam from a laser-produced plasma (LPP), comprising:

    a vacuum chamber (1) containing a rotational drive unit (2) coupled to a rotating target assembly (3) which supplies a target (4) to an interaction zone (5), an input window (6) for a pulsed laser beam (7) focused into the interaction zone, an output window (8) for an exit of the short-wavelength radiation beam (9), and gas inlets (10), and
    the rotating target assembly (3) has an annular groove (11) with a distal wall (13) and a proximal wall (14) relative to an axis of rotation (12);
    the apparatus configured such that when in use the plasma-forming target material (15) is a molten metal located inside the annular groove (11), and the proximal wall (14) of the annular groove (11) is designed to provide a line of sight between the interaction zone (5) and both the input and output windows (6), (8) particularly during laser pulses,
    **characterised in that**
    the target (4) is a layer of said molten metal formed by a centrifugal force on a surface (16) of the distal wall (13) of the annular groove (11).

2.  The apparatus according to claim 1, wherein the proximal wall (14) of the annular groove (11) has n pairs of openings (17) and (18) arranged on a groove circumference, in each of the pairs, a first opening (17) is provided for a focused laser beam (7) input into the interaction zone (5), and a second opening (18) is provided for a short-wavelength radiation beam (9) output from the interaction zone during the laser pulses that follow at a frequency f equal to a target assembly rotational speed (v) multiplied by the number of the opening pairs n:

$$f = v \cdot n,$$

    further comprising a synchronization system which adjusts the annular groove (11) rotation angle with laser pulses timed to provide a line of sight between the interaction zone (5) and both the input and output windows (6) and (8).

3.  The apparatus according to claim 2, wherein each twin openings (17) and (18) are joined.

4. The apparatus according to claim 1, wherein the proximal wall (14) of the annular groove (11) has a slit along its entire perimeter providing a line of sight between the interaction zone (5) and both the input and output windows (6) and (8).

5. The apparatus according to claim 1, wherein the rotating target assembly (3) is provided with a fixed heating system (28) for the target material (15).

6. The apparatus according to claim 1, wherein the laser beam (7) and the short-wavelength radiation beam (9) are located on one side of a rotation plane (19) passing through the interaction zone (5), and wherein either a normal vector (20) to the annular groove surface (16) in the interaction zone (5) is located on the opposite side of the rotation plane (19), or wherein the rotational drive unit (2) is located on the opposite side of the rotation plane (19).

7. The apparatus according to claim 1, wherein a part of the focused laser beam (7) between the input window (6) and the proximal wall (14) of the annular groove (11) is surrounded by a first casing (22) in which a gas flow from the input window (6) to the proximal wall (14) of the annular groove (11) is supplied, and a part of the short-wavelength radiation beam (9) between the proximal wall (14) of the annular groove (11) and the output window (8) is surrounded by a second casing (23) in which a gas flow from the output window (8) to the proximal wall (14) of the annular groove (11) is supplied.

8. The apparatus according to claim 7, wherein devices for magnetic field generation (26) are arranged on outer surfaces of the first and second casings (22) and (23).

9. The apparatus according to claim 1, wherein the input and output windows (6), (8) are provided with heaters (29) performing cleaning by evaporation of debris from the windows (6), (8).

10. The apparatus according to claim 1, wherein the input and output windows (6), (8) are provided with a system of gas chemical cleaning.

11. The apparatus according to claim 1, wherein the plasma-forming target material is selected from metals providing extreme ultraviolet (EUV) light generation, particularly including Sn, Li, In, Ga, Pb, Bi or their alloys.

12. A method for generating radiation from a laser-produced plasma, comprising:

forming a target (4) by centrifugal force as a layer of molten metal on a surface (16) of an annular groove (11) with a distal wall (13) and a proximal wall (14) relative to an axis of rotation (12), implemented inside a rotating target assembly (3);
sending a pulsed laser beam (7) through an input window (6)) of a vacuum chamber (1) into an interaction zone (5) while providing a line of sight between the interaction zone (5) and both the input and output windows (6), (8) particularly during laser pulses, irradiating a target (4) on a surface of the distal wall (13) of the annular groove of the rotating target assembly (3) by a laser beam (7), and passing a generated short-wavelength radiation beam (9) through an output window (8) of a vacuum chamber (1).

13. A method for mitigating debris in a laser-produced plasma (LPP) source, **characterized by** generating radiation according to the method of claim 12, said method further comprising: using an orbital velocity $V_R$ of the rotating target assembly (3) high enough for the droplet fractions of the debris particles exiting the rotating target assembly not to be directed towards the input and output windows (6) and (8).

14. The method according to claim 13, wherein the groove has a distal wall (13) and a proximal wall (14) relative to an axis of rotation (12); the proximal wall (14) has n pairs of openings (17), (18) arranged for the focused laser beam (7) input into an interaction zone (5) and for a short-wavelength radiation beam (9) output from the interaction zone (5) during the laser pulses that follow at a frequency f equal to the orbital velocity $V_R$ of the rotating target assembly (3) multiplied by the number n of the opening pairs and divided by the length of the orbital circle $2\pi R$: $f = V_R.n/(2\pi R)$, said method comprising:

forming the target (4) on a surface (16) of the distal wall (13) of the annular groove (11),
providing a line of sight between the interaction zone (5) and both the input and output windows (6) and (8) by means of two openings (17), (18),
irradiating a target (4) on the surface of a rotating target assembly (3) by a laser beam (7) and passing a generated short-wavelength radiation beam (9) through the output window (8) of a vacuum chamber (1), restricting a debris flow, generated from the interaction zone (5), by apertures of two openings (17), (18), obstructing the passage of the debris through the proximal wall (14), by closing the line of sight between the interaction zone (5) and both the input and output windows (6), (8) due to rotation of the proximal wall (14) until the next cycle of operation.

15. The method according to claim 14, wherein openings (17), (18) are elongated channels, which act as rotating debris-trapping surfaces, and said method comprising: trapping the debris particles on the surfaces of the said elongated channels (17), (18) and ejecting the trapped debris particles by centrifugal force back into the groove (11).

**Patentansprüche**

1. Einrichtung zum Generieren eines kurzwelligen Strahlenbündels aus einem Laser-erzeugten Plasma (*laser-produced plasma* - LPP), die Folgendes umfasst:

   eine Vakuumkammer (1), die eine Rotationsantriebseinheit (2), die mit einer rotierenden Zielanordnung (3) gekoppelt ist, die ein Ziel (4) einer Interaktionszone (5) zuführt, ein Eingabefenster (6) für einen gepulsten Laserstrahl (7), der in die Interaktionszone fokussiert, ein Ausgabefenster (8) für einen Ausgang des kurzwelligen Strahlenbündels (9) und Gaseinlässe (10) enthält,
   und
   wobei die rotierende Zielanordnung (3) eine Ringnut (11) mit einer distalen Wand (13) und einer proximalen Wand (14) relativ zu einer Rotationsachse (12) aufweist;
   wobei die Einrichtung derart konfiguriert ist, dass, wenn sie verwendet wird,
   das Plasma ausbildende Zielmaterial (15) ein geschmolzenes Metall ist, das sich innerhalb der Ringnut (11) befindet,
   und die proximale Wand (14) der Ringnut (11) konzipiert ist, um eine Sichtlinie zwischen der Interaktionszone (5) und sowohl dem Eingabe- als auch dem Ausgabefenster (6), (8) bereitzustellen, insbesondere während Laserimpulsen,
   **dadurch gekennzeichnet, dass**
   das Ziel (4) eine Schicht des geschmolzenen Metalls ist, die durch eine Zentrifugalkraft auf einer Oberfläche (16) der distalen Wand (13) der Ringnut (11) ausgebildet wird.

2. Einrichtung nach Anspruch 1, wobei die proximale Wand (14) der Ringnut (11) n Paare von Öffnungen (17) und (18) aufweist, die auf einer Nutperipherie angeordnet sind, in jedem der Paare eine erste Öffnung (17) für einen fokussierten Laserstrahl (7) bereitgestellt ist, der in die Interaktionszone (5) eingegeben wird, und eine zweite Öffnung (18) für ein kurzwelliges Strahlenbündel (9) bereitgestellt ist, das aus der Interaktionszone während der Laserimpulse ausgegeben wird, die mit einer Frequenz f folgen, die gleich einer Zielanordnungsdrehzahl (v) ist, die mit der Anzahl der Öffnungspaare n multipliziert wird:

$$f = v \cdot n,$$

   die ferner ein Synchronisationssystem umfasst, das den Drehwinkel der Ringnut (11) mit Laserimpulsen einstellt, die zeitlich abgestimmt sind, um eine Sichtlinie zwischen der Interaktionszone (5) und sowohl dem Eingabe- als auch dem Ausgabefenster (6) und (8) bereitzustellen.

3. Einrichtung nach Anspruch 2, wobei alle Zwillingsöffnungen (17) und (18) vereinigt sind.

4. Einrichtung nach Anspruch 1, wobei die proximale Wand (14) der Ringnut (11) entlang ihres gesamten Umfangs einen Schlitz aufweist, der eine Sichtlinie zwischen der Interaktionszone (5) und sowohl dem Eingabe- als auch dem Ausgabefenster (6) und (8) bereitstellt.

5. Einrichtung nach Anspruch 1, wobei die rotierende Zielanordnung (3) mit einem festen Heizsystem (28) für das Zielmaterial (15) versehen ist.

6. Einrichtung nach Anspruch 1, wobei sich der Laserstrahl (7) und das kurzwellige Strahlenbündel (9) auf einer Seite einer Rotationsebene (19) befinden, die durch die Interaktionszone (5) verläuft, und wobei sich entweder ein Normalenvektor (20) zu der Ringnutoberfläche (16) in der Interaktionszone (5) auf der gegenüberliegenden Seite der Rotationsebene (19) befindet oder wobei sich die Rotationsantriebseinheit (2) auf der gegenüberliegenden Seite der Rotationsebene (19) befindet.

7. Einrichtung nach Anspruch 1, wobei ein Teil des fokussierten Laserstrahls (7) zwischen dem Eingabefenster (6) und der proximalen Wand (14) der Ringnut (11) von einem ersten Gehäuse (22) umgeben ist, in dem ein Gasstrom von dem Eingabefenster (6) zu der proximalen Wand (14) der Ringnut (11) zugeführt wird, und ein Teil des kurzwelligen Strahlenbündels (9) zwischen der proximalen Wand (14) der Ringnut (11) und dem Ausgabefenster (8) von einem zweiten Gehäuse (23) umgeben ist, in dem ein Gasstrom von dem Ausgabefenster (8) zu der proximalen Wand (14) der Ringnut (11) zugeführt wird.

8. Einrichtung nach Anspruch 7, wobei Vorrichtungen zur Magnetfeldgeneration (26) an Außenoberflächen des ersten und des zweiten Gehäuses (22) und (23) angeordnet sind.

9. Einrichtung nach Anspruch 1, wobei das Eingabe- und das Ausgabefenster (6), (8) mit Heizelementen (29) versehen sind, die eine Reinigung durch Verdampfen von Trümmerteilen von den Fenstern (6), (8) durchführen.

10. Einrichtung nach Anspruch 1, wobei das Eingabe- und das Ausgabefenster (6), (8) mit einem System einer chemischen Gasreinigung versehen sind.

11. Einrichtung nach Anspruch 1, wobei das Plasma ausbildende Zielmaterial aus Metallen ausgewählt ist, die eine Generation von extremem Ultraviolett(*Extreme Ultraviolet*- EUV)-Licht bereitstellen, insbesondere einschließlich Sn, Li, In, Ga, Pb, Bi oder deren Legierungen.

12. Verfahren zum Generieren von Strahlung aus einem Laser-erzeugten Plasma, das Folgendes umfasst:

Ausbilden eines Ziels (4) durch Zentrifugalkraft als eine Schicht aus geschmolzenem Metall auf einer Oberfläche (16) einer Ringnut (11) mit einer distalen Wand (13) und einer proximalen Wand (14) relativ zu einer Rotationsachse (12), die innerhalb einer rotierenden Zielanordnung (3) implementiert ist;
Senden eines gepulsten Laserstrahls (7) durch ein Eingabefenster (6) einer Vakuumkammer (1) in eine Interaktionszone (5), während eine Sichtlinie zwischen der Interaktionszone (5) und sowohl dem Eingabe- als auch dem Ausgabefenster (6), (8), bereitgestellt wird, insbesondere während Laserimpulsen, Bestrahlen eines Ziels (4) auf einer Oberfläche der distalen Wand (13) der Ringnut der rotierenden Zielanordnung (3) durch einen Laserstrahl (7),
und Leiten eines generierten kurzwelligen Strahlenbündels (9) durch ein Ausgabefenster (8) einer Vakuumkammer (1).

13. Verfahren zum Abschwächen von Trümmerteilen in einer Quelle für Laser-erzeugtes Plasma (LPP), **gekennzeichnet durch** das Generieren von Strahlung gemäß dem Verfahren nach Anspruch 12, wobei das Verfahren ferner Folgendes umfasst:
Verwenden einer Orbitalgeschwindigkeit $V_R$ der rotierenden Zielanordnung (3), die hoch genug ist, dass die Tropfenfraktionen der Trümmerteilpartikel, die aus der rotierenden Zielanordnung austreten, nicht in Richtung des Eingabe- und des Ausgabefensters (6) und (8) gelenkt werden.

14. Verfahren nach Anspruch 13, wobei die Nut eine distale Wand (13) und eine proximale Wand (14) relativ zu einer Rotationsachse (12) aufweist; die proximale Wand (14) n Paare von Öffnungen (17), (18) aufweist, die für den fokussierten Laserstrahl (7), der in eine Interaktionszone (5) eingegeben wird, und für ein kurzwelliges Strahlenbündel (9) angeordnet sind, das aus der Interaktionszone (5) während der Laserimpulse ausgegeben wird, die bei einer Frequenz f folgen, die gleich der Orbitalgeschwindigkeit $V_R$ der rotierenden Zielanordnung (3) multipliziert mit der Anzahl n der Öffnungspaare und dividiert durch die Länge des Umlaufkreises ist, $2\pi R$: $f = V_R \cdot n/(2\pi R)$, wobei das Verfahren Folgendes umfasst:

Ausbilden des Ziels (4) auf einer Oberfläche (16) der distalen Wand (13) der Ringnut (11),
Bereitstellen einer Sichtlinie zwischen der Interaktionszone (5) und sowohl dem Eingabe- als auch dem Ausgabefenster (6) und (8) mittels zweier Öffnungen (17), (18),
Bestrahlen eines Ziels (4) auf der Oberfläche einer rotierenden Zielanordnung (3) durch einen Laserstrahl (7) und Leiten eines generierten kurzwelligen Strahlenbündels (9) durch das Ausgabefenster (8) einer Vakuumkammer (1),

Beschränken eines Trümmerteilstroms, der aus der Interaktionszone (5) generiert wird, durch Mündungen von zwei Öffnungen (17), (18),
Blockieren des Durchgangs der Trümmerteile durch die proximale Wand (14) durch Schließen der Sichtlinie zwischen der Interaktionszone (5) und sowohl dem Eingabe- als auch dem Ausgabefenster (6), (8) aufgrund einer Rotation der proximalen Wand (14) bis zu dem nächsten Betriebszyklus.

15. Verfahren nach Anspruch 14, wobei die Öffnungen (17), (18) längliche Kanäle sind, die als rotierende, Trümmerteile auffangende Oberflächen wirken, und wobei das Verfahren Folgendes umfasst:
Auffangen der Trümmerteilpartikel auf den Oberflächen der länglichen Kanäle (17), (18) und Ausstoßen der aufgefangenen Trümmerteilpartikel durch Zentrifugalkraft zurück in die Nut (11).

**Revendications**

1. Appareil de génération d'un faisceau de rayonnement de courtes longueurs d'onde à partir d'un plasma produit par laser (LPP), comprenant :

une enceinte à vide (1) contenant une unité d'entraînement en rotation (2) accouplée à un ensemble cible rotatif (3) qui fournit une cible (4) à une zone d'interaction (5), une fenêtre d'entrée (6) pour un faisceau laser pulsé (7) focalisé dans la zone d'interaction, une fenêtre de sortie (8) pour une sortie du faisceau de rayonnement de courtes longueurs d'onde (9) et des injections de gaz (10),
et
l'ensemble cible rotatif (3) présente une rainure annulaire (11) dotée d'une paroi distale (13) et d'une paroi proximale (14) par rapport à un axe de rotation (12) ;
l'appareil étant conçu de telle sorte que lors de son utilisation
le matériau cible formant un plasma (15) est un métal fondu situé à l'intérieur de la rainure annulaire (11),
et la paroi proximale (14) de la rainure annulaire (11) est conçue pour fournir une ligne de vue entre la zone d'interaction (5) et à la fois les fenêtres d'entrée et de sortie (6), (8) en particulier pendant les impulsions laser,
**caractérisé en ce que**
la cible (4) est une couche dudit métal fondu formée par une force centrifuge sur une surface (16) de la paroi distale (13) de la rainure annulaire (11).

2. Appareil selon la revendication 1, dans lequel la paroi proximale (14) de la rainure annulaire (11) présente n paires d'ouvertures (17) et (18) agencées sur une circonférence de rainure, dans chacune des paires, une première ouverture (17) est prévue pour une entrée de faisceau laser focalisé (7) dans la zone d'interaction (5), et une seconde ouverture (18) est prévue pour une sortie de faisceau de rayonnement de courtes longueurs d'onde (9) depuis la zone d'interaction pendant les impulsions laser qui suivent à une fréquence f égale à une vitesse de rotation d'ensemble cible (v) multipliée par le nombre de paires d'ouvertures n :

$$f = v \cdot n,$$

comprenant en outre un système de synchronisation qui règle l'angle de rotation de la rainure annulaire (11) avec des impulsions laser temporisées pour fournir une ligne de vue entre la zone d'interaction (5) et les fenêtres d'entrée et de sortie (6) et (8).

3. Appareil selon la revendication 2, dans lequel chacune des ouvertures jumelles (17) et (18) est jointe.

4. Appareil selon la revendication 1, dans lequel la paroi proximale (14) de la rainure annulaire (11) présente une fente sur tout son périmètre fournissant une ligne de vue entre la zone d'interaction (5) et les fenêtres d'entrée et de sortie (6) et (8).

5. Appareil selon la revendication 1, dans lequel l'ensemble cible rotatif (3) est pourvu d'un système de chauffage fixe (28) pour le matériau cible (15).

6. Appareil selon la revendication 1, dans lequel le faisceau laser (7) et le faisceau de rayonnement de courtes longueurs d'onde (9) sont situés sur un côté d'un plan de rotation (19) passant à travers la zone d'interaction (5), et dans lequel soit un vecteur normal (20) à la surface de rainure annulaire (16) dans la zone d'interaction (5) est situé sur le côté opposé du plan de rotation (19), ou dans lequel l'unité d'entraînement en rotation (2) est située sur le côté opposé du plan de rotation (19).

7. Appareil selon la revendication 1, dans lequel une partie du faisceau laser focalisé (7) entre la fenêtre d'entrée (6) et la paroi proximale (14) de la rainure annulaire (11) est entourée par un premier boîtier (22) dans lequel est fourni un écoulement gazeux provenant de la fenêtre d'entrée (6) vers la paroi proximale (14) de la rainure annulaire (11), et une partie du faisceau de rayonnement de courtes longueurs d'onde (9) entre la paroi proximale (14) de la rainure annulaire (11) et la fenêtre de sortie (8) est entourée d'un second boîtier (23) dans lequel est fourni un écoulement gazeux provenant de la fenêtre de sortie (8) vers la paroi proximale (14) de la rainure annulaire (11).

8. Appareil selon la revendication 7, dans lequel des dispositifs de génération de champ magnétique (26) sont disposés sur les surfaces externes des premier et second boîtiers (22) et (23).

9. Appareil selon la revendication 1, dans lequel les fenêtres d'entrée et de sortie (6), (8) sont pourvues de réchauffeurs (29) effectuant le nettoyage par évaporation des débris provenant des fenêtres (6), (8).

10. Appareil selon la revendication 1, dans lequel les fenêtres d'entrée et de sortie (6), (8) sont pourvues d'un système de nettoyage chimique des gaz.

11. Appareil selon la revendication 1, dans lequel le matériau cible formant un plasma est choisi parmi les métaux fournissant une génération de lumière ultraviolette extrême (UVE), en particulier comportant Sn, Li, In, Ga, Pb, Bi ou leurs alliages.

12. Procédé de génération d'un rayonnement à partir d'un plasma produit par laser, comprenant :

la formation d'une cible (4) par la force centrifuge sous forme de couche de métal fondu sur une surface (16) d'une rainure annulaire (11) dotée d'une paroi distale (13) et d'une paroi proximale (14) par rapport à un axe de rotation (12), mis en œuvre à l'intérieur d'un ensemble cible rotatif (3) ;
l'envoi d'un faisceau laser pulsé (7) à travers une fenêtre d'entrée (6) d'une enceinte à vide (1) dans une zone d'interaction (5) tout en fournissant une ligne de vue entre la zone d'interaction (5) et les fenêtres d'entrée et de sortie (6), (8) en particulier pendant les impulsions laser, l'irradiation d'une cible (4) sur une surface de la paroi distale (13) de la rainure annulaire de l'ensemble cible rotatif (3) par un faisceau laser (7), et le passage d'un faisceau de rayonnement de courtes longueurs d'onde généré (9) à travers une fenêtre de sortie (8) d'une enceinte à vide (1).

13. Procédé d'atténuation de débris dans une source de plasma produit par laser (LPP), **caractérisé par** la génération d'un rayonnement selon le procédé de la revendication 12, ledit procédé comprenant en outre :
l'utilisation d'une vitesse orbitale $V_R$ de l'ensemble cible rotatif (3) suffisamment élevée pour que les fractions de gouttelette des particules de débris sortant de l'ensemble cible rotatif ne soient pas dirigées vers les fenêtres d'entrée et de sortie (6) et (8).

14. Procédé selon la revendication 13, dans lequel la rainure présente une paroi distale (13) et une paroi proximale (14) par rapport à un axe de rotation (12) ; la paroi proximale (14) présente n paires d'ouvertures (17), (18) agencées pour l'entrée du faisceau laser focalisé (7) dans une zone d'interaction (5) et pour une sortie de faisceau de rayonnement de courtes longueurs d'onde (9) de la zone d'interaction (5) pendant les impulsions laser qui suivent à une fréquence f égale à la vitesse orbitale $V_R$ de l'ensemble cible rotatif (3) multipliée par le nombre n des paires d'ouvertures et divisée par la longueur du cercle orbitaire $2\pi R$ : $f = VR \cdot n / (2\pi R)$, ledit procédé comprenant :

la formation de la cible (4) sur une surface (16) de la paroi distale (13) de la rainure annulaire (11),
la fourniture d'une ligne de vue entre la zone d'interaction (5) et à la fois les fenêtres d'entrée et de sortie (6) et (8) au moyen de deux ouvertures (17), (18), l'irradiation d'une cible (4) sur la surface d'un ensemble cible rotatif (3) par un faisceau laser (7) et le passage d'un faisceau de rayonnement de courtes longueurs d'onde (9) généré à travers la fenêtre de sortie (8) d'une enceinte à vide (1),
la restriction d'une coulée de débris, généré à partir de la zone d'interaction (5), par les embouchures de deux ouvertures (17), (18),
l'obstruction du passage des débris à travers la paroi proximale (14), en fermant la ligne de vue entre la zone d'interaction (5) et les fenêtres d'entrée et de sortie (6), (8) en raison de la rotation de la paroi proximale (14) jusqu'au prochain cycle de fonctionnement.

15. Procédé selon la revendication 14, dans lequel les ouvertures (17), (18) sont des canaux allongés, qui agissent comme des surfaces rotatives de piégeage de débris, et ledit procédé comprenant :
le piégeage des particules de débris sur les surfaces desdits canaux allongés (17), (18) et l'éjection des particules de débris piégées par la force centrifuge dans la rainure (11).

Fig. 1

Fig. 2

Fig. 3

Fig. 4

Fig. 5

$$\left|\vec{V_R}\right| = 0$$

Fig. 6

$$\left|\vec{V_R}\right| > \left|\vec{V_{d0}}\right|\left[sin(\gamma/2) + cos(\gamma/2)\tan(\alpha/2)\,\right]$$

Fig. 7

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7307375 B
- US 20150076359 A
- US 8344339 B
- US 8519366 B
- US 7302043 B